# EUROPÄISCHE PATENTSCHRIFT

(11) **EP 0 559 967 B1**
(45) Veröffentlichungstag und Bekanntmachung des Hinweises auf die Patenterteilung: **20.03.1996**
(21) Anmeldenummer: 92121836.8
(22) Anmeldetag: 22.12.1992
(51) Int. Cl.: C03C 17/36, C23C 14/18

(54) **Antikspiegel und Verfahren zur Herstellung desselben**
Antique mirror and its manufacturing process
Miroir antique et procédé pour le fabriquer

(30) Priorität: 18.02.1992 DE 4204763
(43) Veröffentlichungstag der Anmeldung: 15.09.1993
(73) Patentinhaber: FRAUNHOFER-GESELLSCHAFT ZUR FÖRDERUNG DER ANGEWANDTEN FORSCHUNG E.V., D-80636 München (DE)
(72) Erfinder: Nedon, Wolfgang, W-8060 Dresden (DE); Schneider, Siegfried, W-8122 Radebeul (DE)
(74) Vertreter: Grünecker, Kinkeldey, Stockmair & Schwanhäusser Anwaltssozietät

(56) Entgegenhaltungen:
- EP-A- 0 177 834
- EP-A- 0 456 488
- DE-A- 3 820 444
- FR-A- 2 518 761
- GB-A- 2 080 339
- DATABASE WPI Week 7216, Derwent Publications Ltd., London, GB; AN 72-25649T
- OBERFLAECHE + JOT Bd. 27, Nr. 12, 1987, MUENCHEN D 'Dünne Schichten für Spiegelkabinett.' Seiten 16, 18, 21

## Beschreibung

Die Erfindung betrifft einen Antikspiegel, auch Barockspiegel genannt, und ein Verfahren zur Herstellung desselben. Antikspiegel haben im allgemeinen eine niedrigere Reflexion als Spiegel auf Silbernitratbasis. Antikspiegel werden in Schlössern, Klöstern, Galerien und Museen verwendet. Durch den warmen Ton des dunkleren Reflexionsbildes werden die Raumgrenzen nicht verwischt, d.h. derartige Spiegel bilden einen sogenannten Fond. Vor solchen Spiegeln aufgestellte Exponate heben sich deutlich von ihrem Spiegelbild ab.

Es ist bekannt, für derartige Spiegel als Reflexionsschicht Zinn zu verwenden, welches dem Spiegel diese gewünschten Eigenschaften verleiht. Dazu wird eine dünne Sn-Folie auf eine mit Hg übergossene Scheibe gelegt. Danach wird die Scheibe in die senkrechte Lage gebracht. Dabei läuft ein Teil des Hg herab und es verbleibt zwischen der Sn-Folie und dem Glas ein dünner Hg-Film, der nur als Haftmittel zwischen der Sn-Folie und dem Glas wirkt.

Neben der Tatsache, daß der Spiegel mit Hg belastet ist, ist vor allem das Verfahren zu seiner Herstellung stark gesundheitsschädlich und darf aus Umweltschutzgründen heute nicht mehr angewandt werden. Weiterhin treten ständig Hg-Dämpfe aus, die zu Gesundheitsschäden führen können. Selbst nach langer Lagerzeit von Spiegeln, z.B. Reservespiegeln, werden noch nach Jahren in den Verpackungen Hg-Tropfen gefunden. Auch in den Räumen, in denen derartige Spiegel angebracht sind, sind Hg-Dämpfe nachweisbar.

Es ist bekannt, die unter Verwendung von Hg verspiegelten Gläser durch Aufdampfen von Legierungen aus Blei und Zinn auf Glas zu ersetzen. Dabei zeigt sich jedoch, daß die Schichten auf dem Glas schlecht haften. Es wurden daher Versuche durchgeführt, Al-Mg-Legierungen mit geringem Si-Gehalt aufzudampfen. Außerdem erfolgte zur Verbesserung der Haftung eine Vorbehandlung durch Glimmentladung. Der fertig bedampfte Spiegel wurde anschließend mit einer Lackschutzschicht versehen (Oberfläche + JOT 1987, H. 12, S. 16-21). Das Verfahren zur Herstellung derartiger Spiegel durch Aufdampfen erfordert einen hohen manuellen und apparativen Aufwand und somit relativ hohe Kosten. Die Produktivität ist auch wesentlich geringer. Ein weiterer Nachteil besteht darin, daß die mechanischen Eigenschaften, insbesondere die Haftfestigkeit, doch noch relativ gering ist. Mit diesem Schichtsystem sind nicht die optischen Eigenschaften erreichbar, um einen vollkommenen und gleichwertigen Ersatz der Spiegel mit Sn-Folie und Hg zu erhalten. Hinzu kommt noch der Mangel, daß nur Brillenrohglas zur Anwendung kommen kann.

Dieser Nachteil zeigt sich vor allem dann, wenn nicht die gesamte Verspiegelung eines Raumes erneuert wird, sondern in dem Raum nur ein Teil der Antikspiegel aus bestimmten Gründen ersetzt werden soll. Aus diesem Grunde wurde bisher kein vollwertiger Ersatz für solche Spiegel gefunden.

Wenn in Schlössern, Klöstern, Galerien, Museen oder für andere Zwecke diese Spiegel ersetzt werden müssen oder neu angebracht werden, ist man gezwungen, auf die beschriebenen Spiegel zurückzugreifen, und muß den Nachteil in Kauf nehmen, daß die speziellen obengenannten Eigenschaften, vor allem die optischen Eigenschaften, nicht erreicht werden.

Der Erfindung liegt daher die Aufgabe zugrunde, einen Antikspiegel zu schaffen, der alle Eigenschaften herkömmlicher Antikspiegel, die mit Sn-Folie unter Verwendung eines Hg-Filmes beschichtet sind, aufweist, ohne daß derartige gesundheitsschädliche Materialien, wie Hg, zur Anwendung kommen.

Der Erfindung liegt insbesondere die Aufgabe zugrunde, einen Antikspiegel anzugeben, der die originalgetreue Restauration vorhandener, teilweise aus früheren Jahrhunderten stammender Originalspiegel ermöglicht und/oder als Ersatzspiegel zum Austausch schadhafter Spiegel dienen kann, ohne daß ein optischer Unterschied zu vorhandenen Spiegeln, die insbesondere aus der Barockzeit stammen, erkennbar ist. Überdies soll der Antikspiegel eine lange Lebensdauer haben.

Der Erfindung liegt ferner die Aufgabe zugrunde, ein Verfahren zur Herstellung eines Antikspiegels anzugeben, daß die völlig originalgetreue Spiegelabbildung wie aus früheren Jahrhunderten stammende originale Antikspiegel ermöglicht und auf der Grundlage bekannter Vakuum-Beschichtungstechniken, vorzugsweise Sputtern, bei hoher Produktivität mit wirtschaftlich vertretbarem Aufwand ausfuhrbar ist und die Herstellung großflächiger Spiegel gestattet.

Die vorgenannte Aufgabe wird hinsichtlich eines Antikspiegels der eingangs genannten Art unter Verwendung von Sn als Reflexionsmaterial erfindungsgemäß dadurch gelöst, daß auf eine Oberfläche einer Flachglasscheibe, vorzugsweise aus Floatglas, eine optisch unwirksame erste Haftschicht aus einem zu Sauerstoff affinen Metall und/oder Metalloxid wie SnO₂ oder Cr, Ti, A1, Ta oder deren Oxiden oder Legierungen besteht,
anschließend eine optisch wirksame Reflexionsschicht aus Sn oder einer Sn-Legierung aufgebracht wird, an die sich eine Schutzschicht aus Cu oder einer Cu-Legierung anschließt, auf welcher eine weitere Haftschicht aus Ti oder einer Ti-Verbindung mit Sauerstoff, Stickstoff oder Kohlenstoff aufgebracht ist, wobei dieses Schichtsystem anschließend von einer Schutzlackschicht abgedeckt ist.

Die vorgenannte Aufgabe wird hinsichtlich des Herstellungsverfahrens für einen Antikspiegel der vorgenannten Art vorzugsweise unter Verwendung einer Magnetron-Sputtereinrichtung erfindungsgemäß dadurch gelöst, daß im Vakuum nach Aktivieren der Oberfläche der Flachglasscheibe eine optisch unwirksame erste Haftschicht aus einem zu Sauerstoff affinen Metall und/oder Metalloxid wie SnO₂ oder Cr, Ti, Al, Ta oder deren Oxiden oder Legierungen aufgebracht wird,
anschließend eine Reflexionsschicht aus Sn oder einer Sn-Legierung aufgebracht wird, anschließend eine Schutzschicht aus Cu oder einer Cu-Legierung aufgebracht wird, anschließend eine weitere Haftschicht aus Ti oder einer Ti-Verbindung mit Sauerstoff, Stickstoff oder Kohlenstoff aufgebracht und anschließend an Luft eine abschließende Schutzlackschicht aufgetragen wird.

Es ist zwar bekannt, Rückspiegel für Fahrzeuge derart herzustellen, daß eine Reflexionsschicht aus Sn, Entspiegelungsschicht und Schutzschicht aufgestäubt sind (DE 34 36 016 C1). Von derartigen Schichten wird aber vorrangig eine hohe Korrosionsbeständigkeit gefordert. Diese wird auch erreicht, aber die Anforderungen an die optischen Eigenschaften sind andere, die mit diesem Schichtaufbau und den Schichtdicken nicht erreichbar sind. Es können nach diesem Verfahren keine Antikspiegel hergestellt werden.

Vorzugsweise weist die optisch wirksame Reflexionsschicht aus Sn eine Dicke von 30 bis 120 nm auf. Die Schutzschicht aus Cu oder einer Cu-Legierung ist vorzugsweise mit einer Dicke von 20 bis 100 nm vorgesehen, während die weitere Haftschicht, die aus Ti oder einer Ti-Verbindung mit Sauerstoff, Stickstoff oder Kohlenstoff besteht,
vorzugsweise eine Dicke von 10 bis 50 nm besitzt. Alle diese Verfahrensschritte werden in Vakuumfolge durchgeführt, wobei es sich zur Vorbereitung der Glasoberfläche als vorteilhaft erwiesen hat, diese als ersten Schritt in der Vakuumfolge mittels Glimmentladung zu reinigen und für die nachfolgende Beschichtung vorzubereiten.

Diese erste, auf der Glasoberfläche aufgebrachte Haftschicht besteht vorzugsweise aus Cr, Ti, Al, Ta oder einer Legierung dieser Metalle, und hat eine Dicke von 1 bis 10 nm.

Es ist auch möglich, daß diese Haftschicht während oder nach dem Aufbringen aufoxidiert wird und 5 bis 20 nm dick ist, oder nur partiell oxidiert ist.

Die Reflexionsschicht kann sowohl aus Sn als auch aus einer Sn-Legierung bestehen und hat vorzugsweise eine Dicke von 30 bis 120 nm.

Die Verwendung von Cu für die Schutzschicht ist aufgrund der Stellung von Cu zu Sn in der Spannungsreihe besonders günstig.

Das Verfahren zur Herstellung der Antikspiegel als ein Vakuum-Beschichtungsverfahren, vorzugsweise mit einer Magnetron-Sputtereinrichtung aus mehreren in Vakuumfolge ablaufenden Verfahrensschritten, wird vorzugsweise so durchgeführt, daß zunächst die Oberfläche einer Flachglasscheibe in einer Glimmentladung oder durch Heizen aktiviert wird. Anschließend wird eine erste, optisch unwirksame Haftschicht aufgebracht, wodurch gleichzeitig das Plasma der Zerstäubungseinrichtung günstig auf das Glas einwirkt. Darauf folgend wird eine Reflexionsschicht aus Sn oder einer Sn-Legierung und anschließend eine Schutzschicht aus Cu oder einer Cu-Legierung aufgebracht. Auf diese Schutzschicht wird eine weitere zweite Haftschicht aus Ti oder TiN aufgebracht, ehe die übliche Beschichtung mit einem Schutzlack erfolgt.

Das fertige Schichtsystem wird vor dem Aufbringen des Schutzlackes zweckmäßigerweise zur Stabilisierung im Vakuum oder auch in einem Reaktionsgas getempert.

Die auf der Glasoberfläche befindliche Haftschicht wird entweder durch Aufbringen, insbesondere Aufsputtern von Cr, Ti, Al, Ta oder deren Legierungen erzeugt, oder diese Sauerstoff affinen Metalle werden während oder unmittelbar nach dem Aufbringen aufoxidiert, indem O₂ in den Beschichtungsraum eingelassen wird.

Vorteilhaft ist es auch, daß diese sauerstoffaffinen Metalle während des Sputterns mit einem Oxidationsgradienten derart aufoxidiert werden, daß die an die Reflexionsschicht angrenzende Fläche dieser Haftschicht metallisch ist.

Eine weitere vorteilhafte Variante des Aufbringens der ersten Haftschicht besteht auch darin, daß bereits während des Glimmens der Glasoberfläche durch Verwendung einer Glimmelektrode aus einem zu Sauerstoff affinen Metall die erste Haftschicht aufgebracht wird.

Das Aufbringen einer, mehrerer oder auch aller Teilschichten erfolgt zweckmäßig durch Sputtern derart, daß eine Magnetron-Zerstäubungseinrichtung so betrieben wird, daß eine maximal mögliche Leistungsdicke vorhanden ist. Weiterhin kann die Plasmaeinwirkung am Substrat definiert eingestellt werden.

Zur Stabilisierung des fertigen Schichtsystems wird vor dem Aufbringen des Schutzlackes ein Temperprozeß durchgeführt. Dieser kann sowohl im Hochvakuum als auch in einer reaktiven Atmosphäre erfolgen. In diesem Fall wird vorteilhafterweise in das Vakuum ein Reaktionsgas, z.B. O₂, N₂ oder ein Gasgemisch aus mindestens einem dieser Gase, eingelassen. Die Temperatur zu dem Temperprozeß sollte zwischen 50 und 150^{o}C liegen.

Das Verfahren ist auch für nichtebene Antikspiegel anwendbar, indem diese vor der Beschichtung geformt werden.

Weitere, bevorzugte Ausführungsformen des Erfindungsgegenstandes sind in den übrigen Unteransprüchen dargelegt.

An einem Ausführungsbeispiel wird die Erfindung nachstehend näher erläutert. Die zugehörige Zeichnung zeigt den Aufbau des Antikspiegels mit dem Schichtsystem.

Eine Flachglasscheibe 1, vorzugsweise Floatglas, wird nach der üblichen mechanischen Vorreinigung in eine Vakuum-Beschichtungsanlage, die im Durchlauf- oder Chargenbetrieb arbeitet, eingebracht. Die Flachglasscheibe 1 durchläuft die einzelnen Stationen, denen die Verfahrensschritte zugeordnet sind.

In einer ersten Station erfolgt die Glimmreinigung zur Aktivierung der Oberfläche. Daran anschließend wird mittels des in der Station angeordneten Magnetrons eine optisch unwirksame Haftschicht 2 aus Cr, die durch gleichzeitiges Zuführen von O₂ in die Beschichtungskammer aufoxidiert, aufgesputtert.

In der nächsten Station wird mit einem Magnetron, das mit hoher Leistungsdichte bei gleichzeitiger Einwirkung von Plasma auf die Oberfläche betrieben wird, die Reflexionsschicht 3 aus Sn aufgesputtert, die entscheidend die optischen Eigenschaften bestimmt. Ihre Dicke beträgt 100 nm.

Auf diese Reflexionsschicht 3 wird ebenfalls eine Schutzschicht 4 aus CuSn₆ und darauf eine weitere Haftschicht 5 aus Ti aufgesputtert. In Vakuumfolge wird dieses Schichtsystem zur Stabilisierung bei der Temperatur von 100^{o}C im Vakuum bei Zuführung von N₂ bei einem Stickstoffpartialdruck von 5 Pa nachbehandelt, d.h. stabilisiert.

In einer letzten Station außerhalb der Vakuum-Beschichtungsanlage wird das fertige Schichtsystem in üblicher Weise mit einem bekannten Schutzlack 6 überzogen.

Auf diese Weise wird ein Antikspiegel geschaffen, der hervorragende, denjenigen originaler Antikspiegel aus dem 17. und 18. Jahrhundert entsprechende optische Eigenschaften, insbesondere hinsichtlich seines Fonds, aufweist. Ein derartiger Spiegel ist sowohl zur Neuausstattung von Räumen oder Vitrinengestaltungen etc. als insbesondere auch zu Restaurationszwecken und zur gemeinsamen Verwendung mit noch original erhaltenen Antikspiegeln aus früheren Jahrhunderten, insbesondere für Schlösser, Klöster, Galerien und Museen verwendbar.

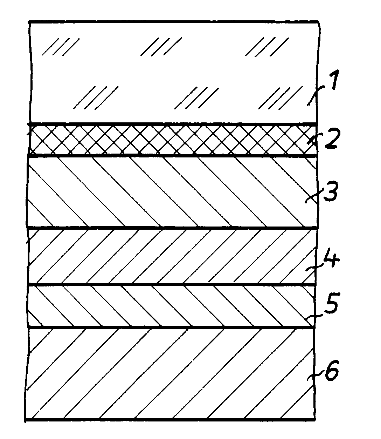

## Patentansprüche

1. Antikspiegel mit Sn als Reflexionsmaterial, bei dem auf einer Oberfläche einer Flachglasscheibe (1) abfolgend ein Schichtsystem aufgebracht ist, mit:
(a) einer optisch unwirksamen ersten Haftschicht (2),die aus einem zu Sauerstoff affinen Metall und/oder Metalloxid, wie SnO₂ oder Cr, Ti, Al, Ta oder dessen Oxiden oder Legierungen besteht,
(b) einer optisch wirksamen Reflexionsschicht (3) aus Sn oder einer Sn-Legierung,
(c) einer Schutzschicht (4) aus Cu oder einer Cu-Legierung,
(d) einer weiteren Haftschicht (5) aus Ti oder einer Ti-Verbindung mit Sauerstoff, Stickstoff oder Kohlenstoff, und
(e) einer Schutzlackschicht (6).

2. Antikspiegel nach Anspruch 1, **dadurch gekennzeichnet,** daß die erste Haftschicht (2) eine Dicke imBereich von 1 bis 10 nm aufweist.

3. Antikspiegel nach Anspruch 1 oder 2, **dadurch gekennzeichnet,** daß die erste Haftschicht (2) auf der Glasoberfläche aufoxidiert oder aufnitriert ist.

4. Antikspiegel nach zumindest einem der vorhergehenden Ansprüche 1 bis 3, **dadurch gekennzeichnet,** daß die Dicke der ersten Haftschicht (2) 5 bis 20 nm beträgt.

5. Antikspiegel nach zumindest einem der vorhergehenden Ansprüche 1 bis 4, **dadurch gekennzeichnet,** daß die Schutzschicht (4) eine Dicke von 20 bis 100 nm aufweist.

6. Antikspiegel nach zumindest einem der vorhergehenden Ansprüche 1 bis 5, **dadurch gekennzeichnet,** daß die zweite Haftschicht (5) eine Dicke von 10 bis 50 nm aufweist.

7. Verfahren zur Herstellung eines Antikspiegels unter Aufbringen eines aus mehreren Schichten bestehenden Schichtsystemes auf eine Flachglasscheibe (1), vorzugsweise mit einer Magnetron-Sputtereinrichtung, insbesondere für einen Antikspiegel nach Anspruch 1, mit den im Vakuum erfolgenden Verfahrensschritten,
(a) daß die Oberfläche der Flachglasscheibe (1) aktiviert wird,
(b) daß eine optisch unwirksame erste Haftschicht (2), die aus einem zu Sauerstoff affinen Metall und/oder Metalloxid wie SnO₂ oder Cr, Ti, Al, Ta oder, dessen Oxiden oder Legierungen besteht, aufgebracht wird,
(c) anschließend eine Reflexionsschicht aus Sn oder einer Sn-Legierung aufgebracht wird,
(d) anschließend eine Schutzschicht aus Cu oder einer Cu-Legierung aufgebracht wird,
(e) anschließend eine weitere Haftschicht aus Ti oder einer Ti-Verbindung mit Sauerstoff, Stickstoff oder Kohlenstoff aufgebracht wird, und
daß anschließend an Luft eine abschließende Schutzlackschicht (6) aufgetragen wird.

8. Verfahren nach Anspruch 7, **dadurch gekennzeichnet,** daß die Schichten des Schichtsystems durch Sputtern aufgebracht werden.

9. Verfahren nach Anspruch 7, **dadurch gekennzeichnet,** daß das Aktivieren der Oberfläche der Flachglasscheibe (1) durch eine Glimmentladung erfolgt.

10. Verfahren nach Anspruch 7, **dadurch gekennzeichnet,** daß das Aktivieren der Oberfläche der Flachglasscheibe (1) durch Aufheizen der Flachglasscheibe (1) erfolgt.

11. Verfahren nach zumindest einem der vorhergehenden Ansprüche 7 bis 10, **dadurch gekennzeichnet,** daß während des Aufbringens der ersten Haftschicht (2) oder unmittelbar im Anschluß daran in den Beschichtungsraum Sauerstoff und/oder Stickstoff zum Aufoxidieren und/oder Aufnitrieren der ersten Haftschicht (2) eingelassen wird.

12. Verfahren nach Anspruch 11, **dadurch gekennzeichnet,** daß die erste Haftschicht (2) während des Aufbringens oder unmittelbar im Anschluß daran durch Sauerstoff- und/oder Stickstoffzufuhr mit einem Oxidations- und/oder Nitrierungsgradienten derart aufoxidiert und/oder nitriert wird, daß eine an die Reflexionsschicht (3) angrenzende Oberfläche der ersten Haftschicht (2) metallisch ist.

13. Verfahren nach zumindest einem der vorhergehenden Ansprüche 7 bis 12, **dadurch gekennzeichnet,** daß gleichzeitig mit der Glimmbehandlung der Glasoberfläche unter Verwendung einer Glimmelektrode die erste Haftschicht (2) aufgebracht wird.

14. Verfahren nach zumindest einem der vorhergehenden Ansprüche 7 bis 13, **dadurch gekennzeichnet,** daß das Aufbringen des Schichtsystemes mit maximal möglicher Leistungsdichte und unter definierter Plasmaeinwirkung durchgeführt wird.

15. Verfahren nach zumindest einem der vorhergehenden Ansprüche 7 bis 14, **dadurch gekennzeichnet,** daß vor dem Aufbringen der Schutzlackschicht (6) das aufgebrachte, Schichtsystem in einem Reaktionsgas, vorzugsweise O₂, N₂, oder einem Gemisch aus mindestens einem dieser Gase bei einer Temperatur von ca. 50 bis 150^{o}C im Vakuum getempert wird.

16. Verfahren nach Anspruch 15, **dadurch gekennzeichnet,** daß der Temperprozeß in Vakuumfolge mit dem Aufbringen des Schichtsystems durchgeführt wird.

## Claims

1. Antique mirror having Sn as the reflective material, wherein there is successively applied to the surface of a flat pane of glass (1) a coating system having:
(a) an optically inactive, first adhesive coating (2) which consists of a metal and/or metal oxide, such as SnO₂ or Cr, Ti, Al, Ta or oxides or alloys thereof, which is affined to oxygen,
(b) an optically active reflective coating (3) of Sn or an Sn alloy,
(c) a protective coating (4) of Cu or a Cu alloy,
(d) a further adhesive coating (5) of Ti or a Ti compound with oxygen, nitrogen or carbon, and
(e) a coating of protective lacquer (6).

2. Antique mirror according to claim 1, **characterized in that** the first adhesive coating (2) has a thickness in the region of 1 to 10 nm.

3. Antique mirror according to claim 1 or 2, **characterized in that** the first adhesive coating (2) is oxidized on or nitrided on on the surface of the glass.

4. Antique mirror according to at least one of the preceding claims 1 to 3, **characterized in that** the thickness of the first adhesive coating (2) is 5 to 20 nm.

5. Antique mirror according to at least one of the preceding claims 1 to 4, **characterized in that** the protective coating (4) has a thickness of 20 to 100 nm.

6. Antique mirror according to at least one of the preceding claims 1 to 5, **characterized in that** the second adhesive coating (5) has a thickness of 10 to 50 nm.

7. Process for manufacturing an antique mirror, with the application of a coating system consisting of a number of coatings to a pane of flat glass (1), preferably with a magnetron sputtering arrangement, in particular for an antique mirror according to claim 1, with the following process steps taking place in vacuo:
(a) the surface of the flat pane of glass (1) is activated,
(b) an optically inactive, first adhesive coating (2), which consists of a metal and/or metal oxide such as SnO₂ or Cr, Ti, Al, Ta or oxides or alloys thereof, which is affined to oxygen, is applied,
(c) then a reflective coating of Sn or an Sn alloy is applied,
(d) then a protective coating of Cu or a Cu alloy is applied,
(e) then a further adhesive coating of Ti or a compound of Ti with oxygen, nitrogen or carbon is applied and,
a final coating of protective lacquer (6) is applied in air.

8. Process according to claim 7, **characterized in that** the coatings of the coating system are applied by sputtering.

9. Process according to claim 7, **characterized in that** the activation of the surface of the flat pane of glass (1) takes place by a glow-discharge operation.

10. Process according to claim 7, **characterized in that** activating of the surface of the flat pane of glass (1) takes place by the heating-up of the flat pane of glass (1).

11. Process according to at least one of the preceding claims 7 to 10, **characterized in that**, during the application of the first adhesive coating (2), or immediately thereafter, oxygen and/or nitrogen is admitted into the coating chamber for oxidizing on and/or nitriding on the first adhesive coating (2).

12. Process according to claim 11, **characterized in that** the first adhesive coating (2) is oxidized on or nitrided on during application, or immediately thereafter, by the feeding-in of oxygen and/or nitrogen with an oxidation and/or nitriding gradient in such a way that a surface of the first adhesive coating (2) that adjoins the reflective coating (3) is metallic.

13. Process according to at least one of the preceding claims 7 to 12, **characterized in that** the first adhesive coating (2) is applied simultaneously with the glow treatment of the surface of the glass using a glow electrode.

14. Process according to at least one of the preceding claims 7 to 13, **characterized in that** the application of the coating system is performed with the maximum possible output density and under the defined effect of plasma.

15. Process according to at least one of the preceding claims 7 to 14, **characterized in that**, before the application of the coating of protective lacquer (6), the applied coating system is annealed in a reaction gas, preferably O₂, N₂, or a mixture of at least one of these gases, at a temperature of about 50 to 150°C in vacuo.

16. Process according to claim 15, **characterized in that** the annealing process is performed in vacuum sequence with the application of the coating system.

## Revendications

1. Miroir antique avec du Sn comme matériau réfléchissant, dans lequel on dépose successivement sur la surface d'une plaque de verre plate (1) un système de couches comprenant :
(a) une première couche d'adhérence (2) optiquement inactive qui est constituée d'un métal ayant une affinité avec l'oxygène et/ou d'oxyde métallique comme le SnO₂ ou le Cr, Ti, Al, Ta ou leurs oxydes ou alliages,
(b) une couche réfléchissante (3) optiquement active en Sn ou en un alliage à base de Sn,
(c) une couche de protection (4) en Cu ou en un alliage à base de Cu,
(d) une autre couche d'adhérence (5) en Ti ou en un composé de Ti avec de l'oxygène, de l'azote ou du carbone, et
(e) une couche de vernis protecteur (6).

2. Miroir antique selon la revendication 1, caractérisé par le fait que la première couche d'adhérence (2) présente une épaisseur comprise entre 1 et 10 nm.

3. Miroir antique selon la revendication 1 ou 2, caractérisé par le fait que la première couche d'adhérence (2) est oxydée ou nitrurée, sur la surface du verre.

4. Miroir antique selon au moins l'une des revendications précédentes 1 à 3, caractérisé par le fait que l'épaisseur de la première couche d'adhérence (2) est comprise entre 5 et 20 nm.

5. Miroir antique selon au moins l'une des revendications précédentes 1 à 4, caractérisé par le fait que la couche de protection (4) a une épaisseur comprise entre 20 et 100 nm.

6. Miroir antique selon au moins l'une des revendications précédentes 1 à 5, caractérisé par le fait que la deuxième couche d'adhérence (5) a une épaisseur comprise entre 10 et 50 nm.

7. Procédé de fabrication d'un miroir antique moyennant le dépôt d'un système de couches, constitué de plusieurs couches, sur une plaque de verre plate (1), de préférence avec un dispositif de pulvérisation à magnétron, en particulier pour un miroir antique selon la revendication 1, comprenant les étapes opératoires, réalisées sous vide, suivantes :
(a) la surface de la plaque de verre plate (1) est activée,
(b) une première couche d'adhérence (2) optiquement inactive, qui est constituée d'un métal ayant une affinité avec l'oxygène et/ou d'oxyde métallique comme le SnO₂ ou le Cr, Ti, Al, Ta ou leurs oxydes ou alliages, est déposée,
(c) une couche réfléchissante en Sn ou en un alliage à base de Sn est ensuite déposée,
(d) une couche de protection en Cu ou en un alliage de Cu est ensuite déposée,
(e) une autre couche d'adhérence en Ti ou en un composé de Ti avec de l'oxygène, de l'azote ou du carbone est ensuite déposée, et une couche terminale de vernis protecteur (6) est ensuite appliquée à l'air.

8. Procédé selon la revendication 7, caractérisé par le fait que les couches du système de couches sont déposées par pulvérisation.

9. Procédé selon la revendication 7, caractérisé par le fait que l'activation de la surface de la plaque de verre plate (1) s'effectue par décharge lumineuse.

10. Procédé selon la revendication 7, caractérisé par le fait que l'activation de la surface de la plaque de verre plate (1) s'effectue par chauffage de ladite plaque de verre plate (1).

11. Procédé selon au moins l'une des revendications précédentes 7 à 10, caractérisé par le fait que pendant le dépôt de la première couche d'adhérence (2) ou directement après, on introduit dans la chambre d'enduction de l'oxygène et/ou de l'azote pour oxyder et/ou nitrurer la première couche d'adhérence (2).

12. Procédé selon la revendication 11, caractérisé par le fait que pendant le dépôt ou directement après, la première couche d'adhérence (2) est oxydée et/ou nitrurée par amenée d'oxygène et/ou d'azote avec un gradient d'oxydation et/ou de nitruration de manière telle qu'une surface adjacente à la couche réfléchissante (3), de la première couche d'adhérence (2) est métallique.

13. Procédé selon au moins l'une des revendications précédentes 7 à 12, caractérisé par le fait que la première couche d'adhérence (2) est déposée en même temps que la surface du verre est traitée par décharge lumineuse à l'aide d'une électrode de décharge.

14. Procédé selon au moins l'une des revendications précédentes 7 à 13, caractérisé par le fait que le dépôt du système de couches s'effectue avec la plus grande densité de puissance possible et avec une action de plasma définie.

15. Procédé selon au moins l'une des revendications précédentes 7 à 14, caractérisé par le fait qu'avant l'application de la couche de vernis protecteur (6), le système de couches déposé est soumis à un recuit sous vide dans un gaz réactionnel, de préférence du O₂, N₂ ou un mélange comprenant au moins un de ces gaz, à une température d'environ 50 à 150°C.

16. Procédé selon la revendication 15, caractérisé par le fait que l'opération de recuit s'effectue sous vide suite à l'application du système de couches.
